# EUROPEAN PATENT SPECIFICATION

(11) **EP 2 341 555 B1**
(45) Date of publication and mention of the grant of the patent: **03.04.2013**
(21) Application number: 11162390.6
(22) Date of filing: 22.04.2008
(51) Int. Cl.: H01L 31/18, H01L 31/0232, H01L 31/0236

(54) **Front electrode including pyrolytic transparent conductive coating on textured glass substrate for use in photovoltaic device and method of making same**
Vorderelektrode, die eine pyrolytische, transparente, leitfähige Beschichtung auf einem texturierten Glassubstrat beinhaltet, zur Verwendung in einer photovoltaischen Vorrichtung und Verfahren zu deren Herstellung
Électrode frontale incluant un revêtement conducteur transparent pyrolytique sur un substrat de verre à motifs pour une utilisation dans un dispositif photovoltaïque et procédé de fabrication correspondant

(30) Priority: 14.06.2007 US 812078
(43) Date of publication of application: 06.07.2011
(62) Divisional of application: 08767391.9
(73) Proprietor: GUARDIAN INDUSTRIES CORP., Auburn Hills, Michigan 48326-1714 (US)
(72) Inventor: Krasnov, Alexey, Canton, MI, 48187 (US); Thomsen, Scott V., South Lyon, MI, 48178 (US)
(74) Representative: Hess, Peter K. G.

(56) References cited:
- US-A- 3 411 934
- US-A- 5 091 764
- US-A- 5 256 858
- US-A1- 2005 016 583

## Description

Certain example embodiments of this invention relate to a photovoltaic device including an electrode such as a front electrode/contact provided on a textured front glass substrate. In certain example embodiments, what is to be the front glass substrate of a photovoltaic device is textured via roller(s) and/or etching to form a textured surface. Thereafter, a front electrode is formed on the textured surface of the glass substrate via pyrolysis, The front electrode may be of or include a transparent conductive oxide (TCO) such as tin oxide and/or fluorinated tin oxide in certain example embodiments, In certain example instances, this is advantageous in that efficiency of the photovoltaic device can be improved by increasing light absorption by the active semiconductor via both increasing light intensity passing through the front glass substrate and front electrode, and increasing the light path in the semiconductor photovoltaic conversion layer.

### BACKGROUND AND SUMMARY OF EXAMPLE EMBODIMENTS OF INVENTION

Photovoltaic devices are known in the art (e.g., see U.S. Patent Nos. 6,784,361, 6,288,325, 6,613,603, and 6,123,824,). Amorphous silicon (a-Si) photovoltaic devices, for example, include a front electrode or contact. Typically, the transparent front electrode is made of a pyrolytic transparent conductive oxide (TCO) such as zinc oxide or tin oxide formed on a substrate such as a glass substrate. Thin film amorphous silicon solar cells are gaining in popularity due to savings in semiconductor material and thus cost; less than 1 µm of Si thickness compared to about 250 µm or so of Si thickness in conventional single crystal Si solar cells. The small thickness of the semiconductor absorber in a-Si solar cells, however, allows a substantial amount of solar light to pass through the absorber without producing electron-hole pairs, thereby lowering the efficiency of the photovoltaic device. There are several ways to increase efficiency of an a-Si solar cell, including roughening of the front electrode. Moreover, higher solar light transmission and higher conductivity of the front electrode may result in higher device efficiency.

In many instances, the transparent front electrode is formed of a single layer using a method of chemical pyrolysis where precursors are sprayed onto the glass substrate at approximately 400 to 600 degrees C. Typical pyrolitic fluorine-doped tin oxide TCOs as front electrodes may be about 400-800 nm thick, which provides for a sheet resistance (Rₛ) of about 7-15 ohms/square. It is known to increase the light path in thin film photovoltaic devices by etching/patterning a surface of a sputtered TCO front electrode after it has been deposited on the front glass substrate. It is also known to deposit some types of TCO on a flat glass substrate in a high process pressure environment in order to cause texturing of the TCO front electrode via column structure growth in the TCO. Unfortunately, both of these techniques often compromise the electrical properties of the TCO front electrode of the photovoltaic device and/or result in an increased thickness of the pre-etched TCO.

Moreover, it is possible to sputter-deposit a zinc aluminum oxide TCO On a glass substrate, and to then etch the surface of the zinc aluminum oxide TCO to be used as the front electrode. However, to achieve a textured sputtered zinc aluminum oxide front electrode, a thicker TCO is needed because the etching of the TCO removes a significant part of the thickness of the material. This removal of a significant part of the TCO thickness is wasteful and results in higher overall costs of the coating.

Document US 2005/016583 A1 describes solar cells with a transparent substrate.

In view of the above, it will be appreciated that there exists a need in the art for an improved front electrode structure, and/or method of making the same, for use in a photovoltaic device or the like.

Certain example embodiments of this invention relate to a photovoltaic device including an electrode such as a front electrode/contact provided on a textured front glass substrate as recited in claim 1. The glass is a low-iron soda-lime-silica based glass in certain example embodiments. In certain example embodiments, what is to be the front glass substrate of a photovoltaic device is textured via roller(s) and/or etching to form a textured surface. Thereafter, a front electrode is formed on the textured surface of the glass substrate via pyrolysis. The pyrolytic front electrode may be of or include a transparent conductive oxide (TCO) such as tin oxide and/or fluorinated tin oxide in certain example embodiments. In alternative example embodiments, the front electrode may be of or include pyrolytic zinc oxide which may or may not be doped with one or more of boron, gallium or other n-type dopant. In certain example instances, this is advantageous in that efficiency of the photovoltaic device can'be improved by increasing light absorption by the active semiconductor via both increasing light intensity passing through the front glass substrate and front electrode, and increasing the light path in the semiconductor photovoltaic conversion layer.

In certain example embodiments, the glass substrate is textured by providing one or a pair of rollers in the float facility and using the patterning roller(s) to texture at least one major surface of the glass substrate in or just after the tin bath but before the pyrolytic TCO front electrode is formed on the glass. After the roller(s) texture the glass, the pyrolytic front electrode is formed on the textured surface of the glass substrate, and it may be used in a photovoltaic device or the like.

In certain example embodiments, the glass substrate is textured by etching (e.g., via hydrofluoric acid or the like, via immersion and/or spraying with the acid inclusive solution). The etching of one or both major surfaces of the glass substrate may be performed after the glass has been made, or alternatively in a float line just after the tin bath but before the pyrolytic TCO front electrode is formed on the glass. In certain example embodiments, the etching may comprise immersing the soda-lime-silica based glass in an acid inclusive solution such as hydrofluoric acid (e.g., HF in aqueous solution) and/or hydrofluoric acid with a buffer, such as BaysO₄ of the like, in order to selectively dissolve some of the glass thereby producing at least one textured/patterned substantially transparent surface of the glass substrate. It has surprisingly been found that in order to achieve good haze properties, the etching ratio of the glass composition, namely (Al₂O₃/Na₂O) x (MgO/CaO) in the glass, is desired to be at least about 0.030, and more preferably at least about 0.035. Moreover, it has also surprisingly been found that in order to achieve good haze properties due to etching, the ratio MgO/CaO in the glass is at least about 0.45, more preferably at least about 0.47. These values have unexpectedly been found to provide for much better haze values compared to if these values are not met. After the glass is textured via such etching, the front electrode is formed on the textured surface of the glass substrate, and it may be used in a photovoltaic device or the like.

In certain example embodiments of this invention, the average roughness at the textured surface of the front glass substrate is from about 0.010 to 1000 µm, more preferably from about 1 to 500 µm, and most preferably from about 1 to 200 µm, or from about 1 to 100 µm.

In certain example embodiments, the pyrolytic front electrode may be formed via spray pyrolysis of the like. In certain example embodiments, the electrode is deposited in a conformal manner so that both major surfaces of the electrode are shaped in a manner similar to that of the textured surface of the glass substrate on which the electrode has been deposited. Thus, the surface of the front electrode closest to the semiconductor absorber film of the photovoltaic device is also textured. In certain example embodiments, there is no need to etch the surface of the front electrode after it has been deposited.

Certain example embodiments of this invention are advantageous in that efficiency of the photovoltaic device can be improved by (a) increasing the solar light trapping within the semiconductor absorber due to the textured surface(s) of both the front electrode and front glass substrate, and (b) increasing the light path in the semiconductor absorber (or photovoltaic conversion layer) due to light scattering at larger angles, while at the same time maintaining good electrical properties of the front electrode.

In certain example embodiments of this invention, there is provided a method of making a photovoltaic device, the method being as recited in claim 12.

### BRIEF DESCRIPTION OF THE DRAWINGS

FIGURE 1 is a cross sectional view of an example photovoltaic device according to an example embodiment of this invention.

FIGURE 2 is a flowchart illustrating certain steps performed in making a photovoltaic device according to an example embodiment of this invention.

### DETAILED DESCRIPTION OF EXAMPLE EMBODIMENTS OF THE INVENTION

Referring now more particularly to the figures in which like reference numerals refer to like parts/layers in the several views.

Photovoltaic devices such as solar cells convert solar radiation into usable electrical energy. The energy conversion occurs typically as the result of the photovoltaic effect. Solar radiation (e.g., sunlight) impinging on a photovoltaic device and absorbed by an active region of semiconductor material (e.g., a semiconductor film including one or more semiconductor layers such as a-Si layers, the semiconductor sometimes being called an absorbing layer or film) generates electron-hole pairs in the active region. The electrons and holes may be separated by an electric field of a junction in the photovoltaic device. The separation of the electrons and holes by the junction results in the generation of an electric current and voltage. In certain example embodiments, the electrons flow toward the region of the semiconductor material having n-type conductivity, and holes flow toward the region of the semiconductor having p-type conductivity. Current can flow through an external circuit connecting the n-type region to the p-type region as light continues to generate electron-hole pairs in the photovoltaic device.

In certain example embodiments, single junction amorphous silicon (a-Si) photovoltaic, devices have a semiconductor film which includes three semiconductor layers. In particular, a p-layer, an n-layer and an i-layer which is intrinsic. The amorphous silicon film (which may include one or more layers such as p, n and i type layers) may be of hydrogenated amorphous silicon in certain instances, but may also be of or include hydrogenated amorphous silicon carbon or hydrogenated amorphous silicon germanium, or the like, in certain example embodiments of this invention. For example and without limitation, when a photon of light is absorbed in the i-layer it gives rise to a unit of electrical current (an electron-hole pair). The p and n-layers, which contain charged dopant ions, set up an electric field across the i-layer which draws the electric charge out of the i-layer and sends it to an optional external circuit where it can provide power for electrical components. It is noted that while certain example embodiments of this invention are directed toward thin film amorphous-silicon based photovoltaic devices (e.g., single-junction or micromorph types), this invention is not so limited and may be used in conjunction with other types of photovoltaic devices in certain instances including but not limited to devices including other types of semiconductor material, single or tandem thin-film solar cells, CdS and/or CdTe photovoltaic devices, polysilicon and/or microcrystalline Si photovoltaic devices, and the like.

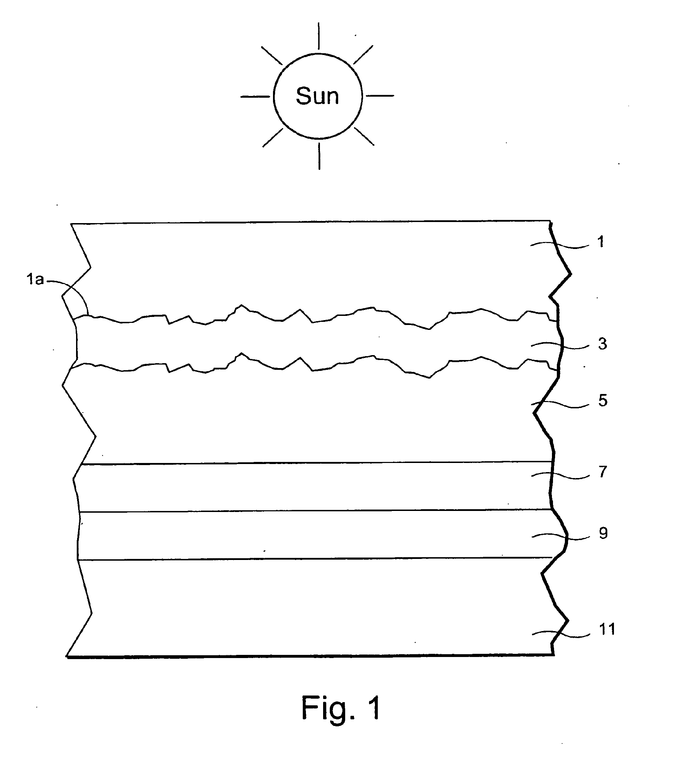

Fig. 1 is a cross sectional view of a photovoltaic device according to an example embodiment of this invention. The photovoltaic device includes transparent front glass substrate 1 having a textured surface 1 a closest to the semiconductor film, front electrode 3 (which may be multi-layered or single-layered), active and absorbing semiconductor film 5 of or including one or more semiconductor layers (such as pin, pn, pinpin tandem layer stacks, or the like), optional back electrode/contact 7 which may be of a TCO and/or metal(s), an optional polymer based encapsulant or adhesive 9 of a material such as ethyl vinyl acetate (EVA) or the like, and an optional rear substrate 11 of a material such as glass. The front glass substrate 1 is on the light incident side of the photovoltaic device. Of course, other layer(s) which are not shown may also be provided in the device. Front glass substrate 1 and/or rear substrate 11 may be made of soda-lime-silica based glass in certain example embodiments of this invention; and may have low iron content and/or an antireflection coating thereon to optimize transmission in certain example instances. Glass 1 and/or 11 may or may not be thermally tempered in certain example embodiments of this invention. Additionally, it will be appreciated that the word "on" as used herein covers both a layer being directly on and indirectly on something, with other layers possibly being located therebetween. Optionally, an antireflective film (not shown) or other film may be provided on the.light-incident side of the front substrate 1 in certain example instances.

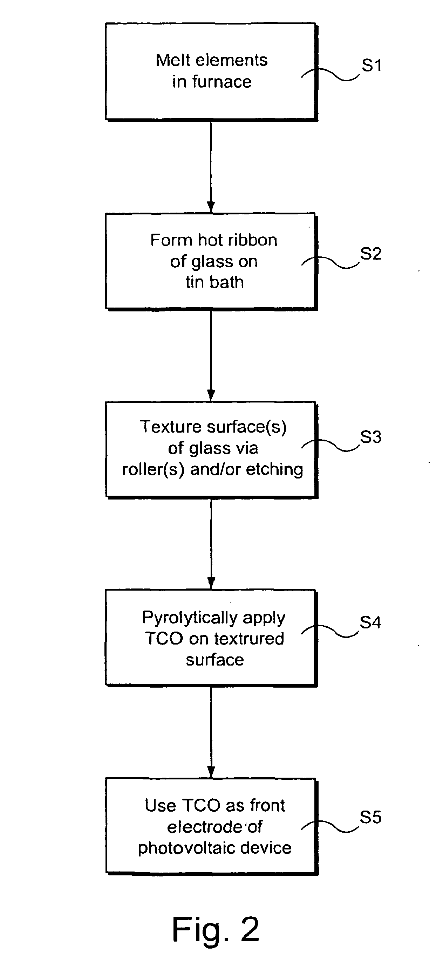

Fig. 2 is a flowchart illustrating a process of making a photovoltaic device according to an example embodiment of this invention. First, the elements (e.g., soda, lime, silica, and optional colorants such as iron and/or the like) are melted in the furnace at the glass-making facility (S 1 in Fig. 2). As is known in the art, in the float process of making glass, the molten material leaves the furnace and glass is formed in the form of a hot ribbon on a tin bath in the tin bath portion of the float process (S2 in Fig. 2). At or soon after the tin bath, one or both major surface(s) of the glass (to be substrate 1) is/are textured (S3 in Fig. 2). As explained herein, this texturing of the glass may be carried out via roller(s) and/or etching in different embodiments of this invention. In certain example embodiments, the texturing (e.g., via roller(s)) may be performed when the glass ribbon is at a temperature of from about 570 to 750 degrees C. After the glass has been textured, a pyrolytic coating (e.g., TCO of or including tin oxide and/or fluorinated tin oxide) is deposited (e.g,. via spray pyrolysis) on the textured surface 1 a of the glass 1 (S4 in Fig. 2). In certain example embodiments, the coating 3 may be applied via spray pyrolysis when the glass ribbon is at a temperature of from about 400-600 degrees C, more preferably from about 400-570 degrees C. After the glass has cooled and optionally been cut, the glass substrate 1 with the coating 3 thereon is used in a photovoltaic device so that the TCO coating 3 is used as a front electrode of the device (S5 in Fig. 2).

In certain example embodiments, the glass substrate 1 is textured by providing one or a pair of rollers in the float facility (in step S3). The patterning roller(s) may be used to texture at least one major surface of the glass substrate 1 in or just after the tin bath but before the pyrolytic TCO front electrode 3 is formed on the glass. While the roller(s) may be used to texture the glass in a float glass making process, it is also possible to use a patterned glass process (having no tin bath) to make and pattern the glass substrate 1 in alternative example embodiments of this invention. In certain example embodiments, the texturing via at least one roller causes a prismatic pattern comprising a feature density of at least five characters per cm² to be formed as the textured surface 1 a, more preferably of at least ten or fifteen characters per cm². After the roller(s) texture the glass 1, the pyrolytic front electrode 3 is formed on the textured surface 1 a of the glass substrate, and it may be used in a photovoltaic device or the like.

In other certain example embodiments, the glass substrate 1 may be textured by etching (e.g., via hydrofluoric acid or the like, via immersion and/or spraying with the acid inclusive solution). The etching of one or both major surfaces of the glass substrate 1 may be performed after the glass has been made, or alternatively in a float line just after the tin bath but before the pyrolytic TCO front electrode 3 is formed on the glass. In certain example embodiments, the etching may comprise immersing the soda-lime-silica based glass 1 in an acid inclusive solution such as hydrofluoric acid (e.g., HF in aqueous solution) and/or hydrofluoric acid with a buffer, such as BaSO₄ of the like, in order to selectively dissolve some of the glass thereby producing at least one textured/patterned substantially transparent surface 1a a of the glass substrate 1. It has surprisingly been found that in order to achieve good haze properties, the etching ratio of the glass composition, namely (Al₂O₃/Na₂O) x (MgO/CaO) in the glass, is desired to be at least about 0.010, more preferably at least about 0.030, and most preferably at least about 0.035. Moreover, it has also surprisingly been found that in order to achieve good haze properties due to etching, the ratio MgO/CaO in the glass is at least about 0.45, more preferably at least about 0.47. These values have unexpectedly been found to provide for much better haze values compared to if these values are not met. After the glass is textured via such etching, the front electrode 3 is formed on the textured surface I a of the glass substrate, and it may be used in a photovoltaic device or the like.

In certain example embodiments, following texturing of the glass 1, the pyrolytic front electrode 3 may be formed via spray pyrolysis of the like. In certain example embodiments, the electrode 3 is deposited in a conformal manner so that both major surfaces of the electrode 3 are shaped in a manner similar to that of the textured surface 1a of the glass substrate 1 on which the electrode has been deposited. Thus, the surface of the front electrode'3 closest to the semiconductor absorber film 5 of the photovoltaic device is also textured. In certain example embodiments, there is no need to'etch the surface of the front electrode 3 after it has been deposited. In certain example embodiments of this invention, the average roughness at the textured surface 1a of the front glass substrate 1 and/or electrode 3 is from about 0.010 to 1000 µm, more preferably from about 1 to 500 µm, and most preferably from about 1 to 200 µm, even more preferably from about 1 to 100 µm.

Certain example embodiments of this invention are advantageous in that efficiency of the photovoltaic device can be improved by (a) increasing the solar light trapping within the semiconductor absorber due to the textured surface(s) of both the front electrode and front glass substrate, and (b) increasing the light path in the semiconductor absorber (or photovoltaic conversion layer) due to light scattering at larger angles, while at the same time maintaining good electrical properties of the front electrode.

The front electrode 3 may be a single-layer of pyrolytic tin oxide (which may or may not be fluorinated in certain example instances) in certain example embodiments. Other materials may instead be used.. In certain example embodiments, such a front electrode 3 may be from about 100 to 1,500 nm thick, more preferably from about 100 to 1,100 nm thick, and most preferably from about 200-800 nm thick. The electrode 3 (e.g., of tin oxide) may contain a fluorine concentration of from about 1-20% in certain example embodiments, more preferably from about 3-15%. Electrode 3 may be deposited in a conformal manner so that both major surfaces of the electrode may be shaped in a manner similar to that of the interior etched/textured surface 1 a of the glass substrate 1 on which the electrode 3 has been deposited. In certain example embodiments, there is no need to etch the surface of the front electrode 3 after it has been deposited. In alternative example embodiments, the front electrode 3 may be made up of multiple layers.

In certain example embodiments of this invention, the average roughness on the etched/textured surface 1a of the front glass substrate 1 and/or the surface of the electrode 3 closest to the semiconductor 5 is from about 0.010 to 1000 µm, more preferably from about 1 to 500 µm, .and most preferably from about 1 to 200 µm or from about 1 to 100 µm (measured as distance between a peak and adjacent valley on the textured surface). The textured surface 1 a of the glass substrate 1 may have a prismatic surface, a matte finish surface, or the like in different example embodiments of this invention. In certain example embodiments, the average peak-to-peak distance between adjacent peaks on the textured surface 1 a of the glass 1 (and/or on the surface of the electrode 3 closest to the semiconductor) is from about 0.010 to 5,000 µm, more preferably from about 10 to 2,000 µm, Because the front electrode is deposited (e.g., sputter-deposited) on' the textured surface 1a of the front substrate, one or possibly both major surfaces of the front electrode 3 may also be textured in a similar manner.

Front glass substrate 1 utilizes soda-lime-silica based glass in certain example embodiments. In addition to base composition/glass, a colorant portion may be provided in order to achieve a glass that is fairly clear in color and/or has a high visible transmission. An exemplary soda-lime-silica base glass according to certain embodiments of this invention, on a weight percentage basis, includes the following basic ingredients:

**TABLE 1: EXAMPLE BASE GLASS**

| Ingredient | Wt. % |
|---|---|
| SiO₂ | 67 - 75 % |
| Na₂O | 10-20% |
| CaO | 5-15% |
| MgO | 0.1-8% |
| Al₂O₃ | 0.1-5% |
| K₂O | 0-5% |

In addition to the base glass (e.g., see Table 1 above), in making glass according to certain example embodiments of the instant invention the glass batch includes materials (including colorants and/or oxidizers) which cause the resulting glass to be fairly neutral in color (slightly yellow in certain example embodiments, indicated by a slightly positive b* value) and/or have a high visible light transmission. These materials may either be present in the raw materials (e.g., small amounts of iron), or maybe added to the base glass materials in the batch (e.g., cerium oxide).

Moreover, in addition to the ingredients in Table 1 above, other minor ingredients, including various conventional refining aids, such as SO₃ and the like may also be included in the base glass. In certain embodiments, for example, glass herein may be made from batch raw materials silica sand, soda ash, dolomite, limestone, with the use.of sulfate salts such as salt cake (Na₂SO₄) and/or Epsom salt (MgSO₄ x 7H₂O) and/or gypsum (e.g., about a 1:1 combination of any) as refining agents. In certain example embodiments, soda-lime-silica based glasses herein include by weight from about 10-15% Na₂O and from about 6-12% CaO. Moreover, from about 0.15 to 7% MgO, more preferably from about 1 to 7% MgO, is provided in the glass in certain example embodiments.

In certain example embodiments of this invention, the.glass of substrate 1 is soda-lime-silica based (see base glass above) and is based on low iron raw materials such that the glass has a total iron (Fe₂O₃) content, in terms of wt%, of no more than about 0.05%. In certain example embodiments, the glass has a total iron (Fe₂O₃) content of from about 0.010 to 0.045%, more preferably from about 0.010 to 0.035%, and most preferably from about 0.010 to 0.029%. This low iron content may result from the use of low-iron raw materials in making the glass, or alternatively may be added in certain example instances. Moreover, in certain example embodiments of this invention, the glass is extremely oxidized so as to have no or very little ferrous (Fe²+; FeO). In certain example embodiments of this invention, the glass has a %FeO of no more than about 0.0038%, more preferably no more than about 0.0030%, even more preferably no more than about 0.0015%, more preferably no more than about 0.0010%. This low. %FeO, in combination with other features, permits the glass to have a higher %UV transmission, and thus a higher %TS transmission, in combination with neutral color and high visible transmission, which are beneficial in solar cell applications. However, more iron than that listed above may be used in the glass 1 in alternative embodiments of this invention.

In certain example non-limiting embodiments, there is no or very little cerium oxide in the glass. Cerium oxide is a UV absorber, and thus prevents UV from being transmitted through the glass. Thus, cerium oxide is not desired in certain solar cell embodiments of this invention. Accordingly, in certain example embodiments of this invention, the glass has no more than about 0.01 % cerium oxide, more preferably no more than about 0.001% cerium oxide, still more preferably no more than about 0.0005% cerium oxide, and most preferably 0% cerium oxide. However, in alternative embodiments of this invention, it is possible to use a small amount of cerium oxide. For example and without limitation, in certain example embodiments of this invention, the glass contains; from about 0 to 0.2% cerium oxide, more preferably from about 0 to 0.1 % cerium oxide, and possibly from about 0.001 to 0.09% cerium oxide. As with all material percentages herein, these amounts are in terms of wt.%. The term cerium oxide as used herein includes Ce₂O₃, CeO₂, or the like. In certain example instances, glasses including cerium oxide herein may be used in applications such as greenhouse glazings where UV protection is desired.

In certain example embodiments of this invention, the colorant portion is substantially free of other colorants (other than potentially trace amounts). However, it should be appreciated that amounts of other materials (e.g., refining aids, melting aids, colorants and/or impurities) may be present in the glass in certain other embodiments of this invention without taking away from the purpose(s) and/or goal(s) of the instant invention. For instance, in certain example embodiments of this invention, the glass composition is substantially free of, or free of, one, two, three, four or all of: erbium oxide, nickel oxide, cobalt oxide, neodymium oxide, chromium oxide, and selenium. The phrase "substantially free" means no more than 2 ppm, more preferably no more than 1 ppm, and possibly as low as 0 ppm of the element or material. It is noted that small amounts of titanium oxide may be included in certain instances.

Glass 1 according to certain example embodiments of this invention achieves a neutral or substantially clear color, high visible transmission, high IR transmission, high UV transmission, and high total solar (TS) transmission. In certain embodiments, resulting glasses according to certain example embodiments of this invention may be characterized by one or more of the following transmissive optical, composition, or color characteristics (for the optics, an example non-limiting reference thickness of about 4 mm is used). Note that Lta is visible transmission %. It is noted that in the table below the L*, a* and b* color values are determined per III, D65, 10 degree Obs.

**TABLE 2: CHARACTERISTICS OF EXAMPLE EMBODIMENTS**

| Characteristic General | More Preferred | Most Preferred | |
|---|---|---|---|
| Lta (Lt D65): | >= 85% | >= 91% | >=91.5% |
| %TS (ISO 9050): | >= 90% | >= 91% | >=91.5% |
| %IR | >= 80% | >=85% | >= 90% (or >= 91%) |
| %UV (300-400 nm): | >= 80% | >= 84% | >= 85% (or 86%) |
| total iron (Fe₂O₃): | <= 0.05% | 0.010-0.045% | 0.010-0.035% |
| %FeO (wt.%): | <= 0.0038% | <= 0.0030% | <= 0.0015% (or |
| 0.0010%) | | | |
| Glass Redox: | <= 0.12 | <= 0.09 | <= 0.08 or 0.06 |
| Batch Redox: | +12 to +30 | +15 to +30 | +20 to +30 |
| SO₃ | >= 0.25 | 0.29-0.50 | >= 0.30 (or >= 0.31) |
| L* (Ill. D65, 10 deg.): | 90-99 | 94-99 | 95-98 |
| a* (Ill. D65, 10 deg.); | -1.0 to +1.0 | -0.5 to +0.5 | -0.25 to 0.0 |
| b* (Ill. D65, 10 deg.): | 0 to + 1.5 | +0.1 to +0.8 | +0.2 to +0.6 |

The aforesaid characteristics of the glass substrate 1 are for the glass substrate alone, not the overall photovoltaic device.

As can be seen from Table 2 above, glasses for substrate 1 of certain embodiments of this invention achieve desired features of fairly clear color and/or high visible transmission, with slightly positive b* color in certain embodiments, while not requiring iron to be eliminated from the glass composition. Moreover, high %UV and high %TS values are also achieved, which is advantageous for solar cell applications in that more radiation is permitted through the glass substrate 1 so that it can be converted to current or voltage. This may be achieved through the provision of the unique material combinations described herein, and/or process features discussed herein. For purposes of example and without'limitation, glasses described in any of commonly owned U.S. Serial Nos. 11/049,292, 11/122,218 and/or 11/373,490 may be used for substrate 1 in different example embodiments of this invention. While these represent example glass that may be used for the substrate, it is of course possible to use other glass compositions for the substrate 1 in alternative embodiments of this invention.

As mentioned above, in order to achieve good haze properties, the soda-lime-silica based glass 1 preferably has an etching ratio [(Al₂O_{3/}Na₂O) x (MgO/CaO)) of at least about 0.010, more preferably at least about 0.030, and most preferably at least about 0.035; and/or a ratio MgO/CaO of at least about 0.45 (more preferably at least about 0.47). These values have unexpectedly been found to provide for much better haze values of the front electrode 3 which is deposited on the textured surface 1a, compared to if these values in the glass are not met.

Referring to S5 in Fig. 2 and Fig. 1 in general, after the electrode 3 has been formed on substrate 1, the semiconductor film 5 (and optionally the optional back contact 7) may be formed on the substrate 1 and front electrode 3 via any suitable technique (e.g., CVD or the like), and then the rear substrate 11 may be laminated to the front electrode, 1 via adhesive film 9 to form the photovoltaic device as shown in Fig. 1 (e.g., see step S3 in Fig. 5). The back contact 7 may or may not be conformal to/with the electrode 3, because the semiconductor 5 may or may not be planarizing in different example embodiments of this invention.

The active semiconductor region or film 5 may include one or more layers, and may be of any suitable material. For example, the active semiconductor film 5 of one type of single junction amorphous silicon (a-Si) photovoltaic device includes three semiconductor layers, namely a p-layer, an n-layer and an i-layer. The p-type a-Si layer of the semiconductor film 5 may be the uppermost portion of the semiconductor film 5 in certain example embodiments of this invention; and the i-layer is typically located between the p and n-type layers. These amorphous silicon based layers of film 5 may be of hydrogenated amorphous silicon in certain instances, but may also be of or include hydrogenated amorphous silicon carbon or hydrogenated amorphous silicon germanium, hydrogenated microcrystalline silicon, or other suitable material(s) in certain example embodiments of this invention. It is possible for the active region 5 to be of a double-junction or triple-junction type in alternative embodiments of this invention. CdTe and/or CdS may also be used for semiconductor film 5 in alternative embodiments of this invention.

Optional back contact or electrode 7 may be of any suitable electrically conductive material. For example and without limitation, the back contact or electrode 7 may be of a TCO and/or a metal in certain instances. Example TCO materials for use as back contact or electrode 7 include indium zinc oxide, indium-tin-oxide (ITO), tin oxide, and/or zinc oxide which may be doped with aluminum (which may or may not be doped with silver). The TCO of the back contact 7 may be of the single layer type or a multi-layer type in different instances. Moreover, the back contact 7 may include both a TCO portion and a metal portion in certain instances. For example, in an example multi-layer embodiment, the TCO portion of the back contact 7 may include a layer of a material such as indium zinc oxide (which may or may not be doped with aluminum or the like), indium-tin-oxide (ITO); tin oxide, and/or zinc oxide closest to the active region 5, and the back contact may include another conductive and possibly reflective layer of a material such as silver, molybdenum, platinum, steel, iron, niobium, titanium, chromium, bismuth, antimony, or aluminum further from the active region 5 and closer to the substrate 11. The metal portion may be closer to substrate 11 compared to the TCO portion of the back contact 7.

The photovoltaic module may be encapsulated or partially covered with an encapsulating material such as encapsulant 9 in certain example embodiments. An example encapsulant or adhesive for layer 9 is EVA or PVB. However, other materials such as Tedlar type plastic, Nuvasil type plastic, Tefzel type plastic or the like may instead be used for layer 9 in different instances.

In certain example embodiments of this invention, it is possible for the glass substrate 1 to have both a patterned side (e.g., patterned via rollers or the like, to form a prismatic side for instance) and a matte finish side. The matter finish side may be formed via acid etching techniques so that the matte finish side of the glass substrate is an acid etched side of the glass. The electrode 3 may be formed on the matte or acid-etched side of the glass substrate 1 which textured to some extent. Moreover, in certain example embodiments of this invention, the glass substrate 1 has a haze value of from about 8-20%, more preferably from about 12-18%.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the scope of the appended claims.

In the following further preferred embodiments are exemplarily disclosed:
1. A method of making a photovoltaic device, the method comprising:
   providing a soda-lime-silica based glass substrate which comprises from about 67-75% SiO₂, from about 10-20% Na₂O from about 5-15% CaO, from about 0.1 to 8% MgO, and from about 0.1 to 5% Al₂O₃;
   texturing at least one major surface of the glass substrate to form a textured surface of the glass substrate;
   after said texturing, pyrolytically forming a transparent conductive oxide based coating comprising tin oxide on the textured surface of the glass substrate; and
   using the pyrolytically formed transparent conductive oxide based coating, formed on the textured surface of the glass substrate, as a front electrode in a photovoltaic device.
2. The method of, 1, wherein the texturing comprises using at least one roller at a temperature of from about 570 to 750 degrees C to form the textured surface of the glass substrate.
3. The method of 2, wherein said texturing using at least one roller causes a prismatic pattern comprising a feature density of at least five characters per cm² to be formed as the textured surface.
4. The method of 2, wherein said texturing using at least one roller causes a prismatic pattern comprising a feature density of at least ten characters per cm² to be formed as the textured surface.
5. The method of 2, wherein said texturing using at least one roller causes a prismatic pattern comprising a feature density of at least fifteen characters per cm² to be formed as the textured surface.
6. The method of 1, wherein said texturing comprises etching the glass substrate using at least one acid to form the textured surface of the glass substrate, wherein an etching ratio ((Al₂O₃/Na₂O) * (MgO/CaO)) of the glass substrate is at least about 0.010.
7. The method of 6, wherein the etching ratio ((Al₂O₃/Na₂O) * (MgO/CaO)) is at least about 0.030.
8. The method of 16, wherein the etching ratio ((Al₂O₃/Na₂O) * (MgO/CaO)) is at least about 0.035.
9. The method of 1, wherein a ratio MgO/CaO in the glass substrate is at least about 0.45
10. The method of 9, wherein the ratio MgO/CaO is at least about 0.47.
11. The method of 16, wherein the texturing comprises etching the glass substrate using at least hydrofluoric acid.
12. The method of 1, further comprising forming the front electrode in a manner so that the transmission of the front electrode and the glass substrate taken together is at least 85% in at least a substantial part of a wavelength range of from about 450-600 nm.
13. The method of 1, wherein the front electrode comprises fluorinated tin oxide.
14. The method of 1, wherein the front electrode is from about 100 to 1,500 nm thick, and comprises tin oxide and/or zinc oxide.
15. The method of 1, wherein said texturing comprises using at least one roller at or soon after a tin bath using in making of the glass substrate to texture the at least one major surface of the glass substrate.
16. The method of 1, wherein an average surface roughness at the textured surface of the front glass substrate and/or a textured surface of the front electrode closest to a semiconductor of the photovoltaic device is from about 1 to 500 µm.
17. The method of 1, wherein an average surface roughness at the textured surface of the front glass substrate and/or a textured surface of the front electrode is from about 1 to 200 µm.
18. The method of 1, wherein the photovoltaic device is a thin film amorphous silicon single-junction or micromorph solar cell.
19. The method of 1, wherein the glass substrate has a total iron (Fe₂O₃) content, in terms of wt.%, of no more than about 0.05%.
20. The method of 1, wherein the front electrode comprises zinc oxide doped with one or more of Al, B, or Ga.
21. A photovoltaic device comprising:
   a soda-lime-silica based glass substrate;
   a semiconductor film;
   a pyrolytic substantially transparent conductive front electrode comprising tin oxide provided between at least the glass substrate and the semiconductor film; and
   wherein a surface of the soda-lime-silica based glass substrate, on which the pyrolytic front electrode comprising tin oxide is provided, is textured so as to have a textured surface with an average surface roughness of from about 1 to 500 µm.
22. The photovoltaic device of 21, wherein the front electrode comprises zinc oxide doped with one or more of Al, B, or Ga.
23. The photovoltaic device of 21, wherein said textured surface comprises a prismatic pattern comprising a feature density of at least ten characters per cm².
24. The photovoltaic device of 21, wherein the average surface roughness of the surface of the glass substrate is from about 1 to 200 µm.
25. The photovoltaic device of 21, wherein a ratio ((Al₂O₃/Na₂O) * (MgO/CaO)) of a composition of the glass substrate is at least about 0.010, and a ratio MgO/CaO of the composition of the glass substrate is at least about 0.45.
26. The photovoltaic device of 21, wherein a ratio ((Al₂O₃/Na₂O) * (MgO/CaO)) of the glass substrate is at least about 0.030.
27. The photovoltaic device of 21, wherein the ratio ((Al₂O₃/Na₂O) ^{*} (MgO/CaO)) is at least about 0.035.
28. The photovoltaic device of 25, wherein the ratio MgO/CaO is at least about 0.47.
29. The photovoltaic device of 21, wherein a transmission of the front electrode and the front glass substrate taken together, into the semiconductor film, is at least 80% in at least a substantial part of a wavelength range of from about 450-600 nm.
30. The photovoltaic device of 21, wherein the glass substrate and/or the front electrode together with the glass substrate has a haze value of from about 8-95%, more preferably from about 8-30%.
31. The photovoltaic device of 21, wherein the glass substrate has a total iron (Fe₂O₃) content, in terms of wt.%, of no more than about 0.05%.
32. The photovoltaic device of 21, wherein the photovoltaic device is a thin film amorphous silicon single-junction or micromorph solar.cell.
33. A method of making a photovoltaic device, the method comprising:
   providing a glass substrate;
   texturing at least one major surface of the glass substrate using at least one roller, at a temperature of from about 570 to 750 degrees C to form a textured surface of the glass substrate;
   after said texturing, pyrolytically forming a transparent conductive oxide based coating comprising tin oxide on the textured surface of the glass substrate; and
   using the pyrolytically formed transparent conductive oxide based coating, formed on the textured surface of the glass substrate, as a front electrode in a photovoltaic device.

## Claims

1. A photovoltaic device comprising:
a soda-lime-silica based glass substrate (1);
a semiconductor film;
a pyrolytic substantially transparent conductive front electrode (3) comprising tin oxide provided between at least the glass substrate (1) and the semiconductor film; and
wherein a surface of the soda-lime-silica based glass substrate (1), on which the pyrolytic front electrode comprising tin oxide is provided, is textured so as to have a textured surface (1a) with an average surface roughness of from about 1 to 500 µm, and **characterized in that** said texturing is obtained by using at least one roller at or soon after a tin bath used in making of the glass substrate to texture the surface, to cause a prismatic pattern comprising a feature density of at least ten characters per cm².

2. The photovoltaic device of claim 1, wherein the front electrode (3) comprises zinc oxide doped with one or more of Al, B, or Ga.

3. The photovoltaic device of claim 1, wherein the average surface roughness of the surface of the glass substrate (1) is from about 1 to 200 µm.

4. The photovoltaic device of claim 1, wherein a ratio ((Al₂O/Na₂O) * (MgO/CaO)) of a composition of the glass substrate (1) is at least about 0.010, and a ratio MgO/CaO of the composition of the glass substrate is at least about 0.45.

5. The photovoltaic device of claim 1, wherein a ratio ((Al₂O₃/Na₂O)* (MgO/CaO)) of the glass substrate (1) is at least about 0.030.

6. The photovoltaic device of claim 1, wherein the ratio ((Al₂O₃/Na₂O)* (MgO/CaO)) is at least about 0.035.

7. The photovoltaic device of claim 4, wherein the ratio MgO/CaO is at least about 0.47.

8. The photovoltaic device of claim 1, wherein a transmission of the front electrode (3) and the front glass substrate (1) taken together, into the semiconductor film, is at least 80% in at least a substantial part of a wavelength range of from about 450-600 nm.

9. The photovoltaic device of claim 1, wherein the glass substrate and/or the front electrode together with the glass substrate (1) has a haze value of from about 8- 95%, more preferably from about 8-30%.

10. The photovoltaic device of claim 1, wherein the glass substrate (1) has a total iron (Fe₂O₃) content, in terms of wt.%, of no more than about 0.05%.

11. The photovoltaic device of claim 1, wherein the photovoltaic device is a thin film amorphous silicon single-junction or micromorph solar cell.

12. A method of making a photovoltaic device, the method comprising:
providing a glass substrate;
texturing at least one major surface of the glass substrate using at least one roller, at a temperature of from about 570 to 750 degrees C to form a textured surface having a prismatic pattern comprising a feature density of at least ten characters per cm²;
after said texturing, pyrolytically forming a transparent conductive oxide based coating comprising tin oxide on the textured surface of the glass substrate; and
using the pyrolytically formed transparent conductive oxide based coating, formed on the textured surface of the glass substrate, as a front electrode in a photovoltaic device.

## Patentansprüche

1. Eine photovoltaische Vorrichtung, umfassend:
ein auf Kalk-Natron basierendes Glas-Substrat (1);
eine Halbleiterschicht;
eine pyrolytische, im Wesentlichen transparente, leitende front Elektrode (3) umfassend Zinnoxid, die zwischen zumindest dem Glasssubstrat (1) und der Halbleiterschicht vorgesehen ist;
wobei eine Oberfläche des auf Kalk-Natron basierenden GlassSubstrats (1), auf welcher die pyrolytische Frontelektrode umfassend Zinnoxid bereit gestellt ist, der Art strukturiert ist, um eine strukturierte Oberfläche (1a) zu haben mit einer durchschnittlichen Oberflächenrauigkeit (average surface roughness) von etwa 1 bis 500µm, und **dadurch gekennzeichnet ist, dass** diese Strukturierung erhalten wird durch Verwendung zumindest einer Walze bei oder kurz nach einem Zinnbad,
welches bei der Herstellung des Glassubstrats verwendet wird,
um die Oberfläche zu strukturieren, um einer prismatischen Struktur mit einer Merkmalsdichte von zumindest 10 Merkmale pro Quadrat cm zu verursachen.

2. Die photovoltaische Vorrichtung nach Anspruch 1, wobei die Frontelektrode (3) Zinkoxid umfasst, dotiert mit einem oder mehreren von Al, B, oder Ga.

3. Die photovoltaische Vorrichtung nach Anspruch 1, wobei die durchschnittliche Oberfläche Rauigkeit der Oberfläche des Glasssubstrates (1) von etwa 1 bis 200 µm beträgt.

4. Die photovoltaische Vorrichtung nach Anspruch 1, wobei ein Verhältnis ((Al₂O/Na₂O) (MgO/CaO)) einer Zusammensetzung des Glasssubstrats (1) zumindest etwa 0,010 ist, und ein Verhältnis MgO/CaO der Zusammensetzung des Glasssubstrats ist zumindest etwa 0,45.

5. Die photovoltaische Vorrichtung nach Anspruch 1, wobei ein Verhältnis die ((Al₂O/Na₂O) * (MgO/CaO)) des Glassubstrats (1) zumindest etwa 0,030 beträgt.

6. Die photovoltaische Vorrichtung nach Anspruch 1, wobei das Verhältnis ((Al₂O/Na₂O) *(MgO/CaO)) zumindest etwa 0,035 beträgt.

7. Die photovoltaische Vorrichtung nach Anspruch 4, wobei das Verhältnis MgO/CaO zumindest etwa 0,47 ist.

8. Die photovoltaische Vorrichtung nach Anspruch 1, wobei eine Transmission der Frontelektrode (3) und des vorderes Glassubstrat (1) zusammen, in die Halbleiterschicht, zumindest 80% in zumindest einem wesentlichen Teil des Wellenlängenspektrums von etwa 450 bis 600 nm beträgt.

9. Die photovoltaische Vorrichtung nach Anspruch 1, wobei das Glasssubstrat und/oder die Frontelektrode zusammen mit dem Glasssubstrat (1) einen Haze-Wert von etwa 8 bis 95% hat, vorzugsweise von etwa 8-30%.

10. Die photovoltaische Vorrichtung nach Anspruch 1, wobei das Glasssubstrat (1) einen Gesamt-Eisen-Gehalt (Fe₂O₃) betrachtet nach Gewichtprozent, von nicht mehr als etwa 0,05% hat.

11. Die photovoltaische Vorrichtung nach Anspruch 1, wobei die photovoltaische Vorrichtung eine Dünnfilm amorphem Silizium Single-Junction oder Mikromorph Solarzelle ist.

12. Ein Verfahren, zur Herstellung einer photovoltaischen Vorrichtung welches Verfahren die folgenden Schritte aufweist:
Bereitstellen eines Glasssubstrats;
strukturieren von zumindest eine Hauptoberfläche des Glasssubstrats unter Verwendung von zumindest eine Walze bei einer Temperatur von etwa 570 bis 750°C, um eine strukturierte Oberfläche mit einer prismatischen Muster zu bilden, dass eine Merkmalsdichte von zumindest 10 Merkmalen pro Quadrat cm umfasst;
nachdem strukturieren, pyrolytisches Aufbringen einer transparenten leitenden Oxid-basierten Beschichtung umfassend Zinnoxid auf der strukturierten Oberfläche des Glasssubstrats;
und
Verwenden der pyrolytisch geformten transparenten leitenden Oxid-basierten Beschichtung, die auf der strukturierten Oberfläche des Glasssubstrats geformt wurde, als eine Frontelektrode in einer photovoltaischen Vorrichtung.

## Revendications

1. Un dispositif photovoltaïque comprenant :
un substrat en verre à base de silice sodocalcique (1) ;
un film semi-conducteur ;
une électrode frontale pyrolytique conductrice substantiellement transparente (3) comprenant de l'oxyde d'étain disposée entre au moins le substrat en verre (1) et le film semi-conducteur ; et
dans lequel une surface du substrat en verre à base de silice sodocalcique (1), sur laquelle est disposée l'électrode frontale pyrolytique comprenant de l'oxyde d'étain, est texturée de manière à présenter une surface texturée (1a) de rugosité moyenne de surface comprise entre environ 1 et 500 µm, et **caractérisé en ce que** ladite texturation est obtenue par emploi d'au moins un rouleau lors de, ou peu après, l'utilisation d'un bain d'étain lors de la fabrication du substrat en verre pour texturer la surface, pour produire un motif prismatique comprenant une densité de caractéristiques d'au moins dix caractères par cm².

2. Le dispositif photovoltaïque de la revendication 1, dans lequel l'électrode frontale (3) comprend de l'oxyde de zinc dopé par un ou plusieurs d'entre Al, B ou Ga.

3. Le dispositif photovoltaïque de la revendication 1, dans lequel la rugosité moyenne de surface de la surface du substrat en verre (1) est comprise entre environ 1 et 200 µm.

4. Le dispositif photovoltaïque de la revendication 1, dans lequel un ratio ((Al₂O₃/Na₂O)*(MgO/CaO)) d'une composition du substrat en verre (1) est d'au moins environ 0,010, et un ratio MgO/CaO de la composition du substrat en verre est d'au moins environ 0,45.

5. Le dispositif photovoltaïque de la revendication 1, dans lequel un ratio ((Al₂O₃/Na₂O)*(MgO/CaO)) du substrat en verre (1) est d'au moins environ 0,030.

6. Le dispositif photovoltaïque de la revendication 1, dans lequel le ratio ((Al₂O₃/Na₂O)*(MgO/CaO)) du substrat en verre (1) est d'au moins environ 0,035.

7. Le dispositif photovoltaïque de la revendication 4, dans lequel le ratio MgO/CaO est d'au moins environ 0,47.

8. Le dispositif photovoltaïque de la revendication 1, dans lequel une transmission de l'électrode frontale (3) et du substrat en verre frontal (1) considérés ensemble, dans le film semi-conducteur, est d'au moins 80 % dans au moins une partie substantielle d'une plage de longueurs d'onde comprises entre environ 450 et 600 nm.

9. Le dispositif photovoltaïque de la revendication 1, dans lequel le substrat en verre et/ou l'élément frontal ensemble avec le substrat en verre (1) présentent une valeur de voile comprise entre environ 8 et 95 %, très préférablement entre environ 8 et 30 %.

10. Le dispositif photovoltaïque de la revendication 1, dans lequel le substrat en verre (1) présente une teneur totale en fer (Fe₂O₃), en termes de pourcentage pondéral, non supérieure à environ 0,05 %.

11. Le dispositif photovoltaïque de la revendication 1, dans lequel le dispositif photovoltaïque est une cellule solaire micromorphe ou à jonction unique en silicium amorphe en film mince.

12. Un procédé de fabrication d'un dispositif photovoltaïque, le procédé comprenant :
l'obtention d'un substrat en verre ;
la texturation d'au moins une surface majeure du substrat en verre par emploi d'au moins un rouleau, à une température comprise entre environ 570 et 750°C pour former une surface texturée présentant un motif prismatique comprenant une densité de caractéristiques d'au moins 10 caractères par cm² ;
après ladite texturation, la formation pyrolytique d'un revêtement à base d'oxyde conducteur transparent comprenant de l'oxyde d'étain sur la surface texturée du substrat en verre ; et
l'utilisation du revêtement à base d'oxyde conducteur transparent formé pyrolytiquement, formé sur la surface texturée du substrat en verre, comme électrode frontale dans un dispositif photovoltaïque.
